Europäisches Patentamt

European Patent Office

Office européen des brevets

(19)

(11) Veröffentlichungsnummer: **0 447 642 A1**

# (12) EUROPÄISCHE PATENTANMELDUNG

(21) Anmeldenummer: 90124180.2

(22) Anmeldetag: 14.12.90

(51) Int. Cl.⁵: **B32B 31/08**, B32B 31/20, B32B 15/14, B32B 15/08, B32B 15/20

Die Bezeichnung der Erfindung wurde geändert (Richtlinien für die Prüfung im EPA, A-III, 7.3).

(30) Priorität: 22.03.90 DE 4009182

(43) Veröffentlichungstag der Anmeldung:
25.09.91 Patentblatt 91/39

(84) Benannte Vertragsstaaten:
DE FR GB IT NL

(71) Anmelder: BAYER AG

W-5090 Leverkusen 1 Bayerwerk(DE)

(72) Erfinder: Becker, Robert, Dr.
Martin-Heidegger-Strasse 8
W-5090 Leverkusen 3(DE)
Erfinder: Goldmann, Gerd, Dr.
Emil-Feinendegen-Strasse 1
W-4150 Krefeld 1(DE)
Erfinder: Elsner, Thomas, Dr.
Südallee 70
W-4000 Düsseldorf 13(DE)
Erfinder: Lindner, Wolfgang, Dr.
Dürerstrasse 15
W-4047 Dormagen 1(DE)

(54) **Verfahren zum kontinuierlichen Herstellen von laminierten Flächengebilden.**

(57) Verfahren zur kontinuierlichen Herstellung von laminierten Flächengebilden aus thermoplastischen Kunststoffen, Verstärkungsfasern und Metallen, in welchem man endlose Flächengebilde aus Verstärkungsfasern, thermoplastische Kunststoffe und Metalle schichtweise vereinigt und die vereinigten Schichten kontinuierlich während einer Zeit von 0,1 bis 10 Minuten bei einer Temperatur von 20 bis 150° C über der Schmelztemperatur des thermoplastischen Kunststoffs einem Druck von 0,5 bis 50 bar aussetzt.

EP 0 447 642 A1

Gegenstand der Erfindung ist ein Verfahren zur kontinuierlichen Herstellung von laminierten Flächengebilden aus thermoplastischen Kunststoffen, Verstärkungsfasern und Metallen, das dadurch gekennzeichnet ist, daß man endlose Flächengebilde aus Verstärkungsfasern, thermoplastische Kunststoffe - bevorzugt ebenfalls als endlose Flächengebilde - und Metalle - bevorzugt ebenfalls als endlose Flächengebilde - schichtweise vereinigt und die vereinigten Schichten kontinuierlich während einer Zeit von 0,1 bis 10 Minuten bei einer Temperatur von 20 bis 150°C über der Schmelztemperatur des thermoplastischen Kunststoffs einem Druck von 0,5 bis 50 bar aussetzt.

Die erfindungsgemäßen laminierten Flächengebilde bestehen letzten Endes aus mit den thermoplastischen Kunststoffen imprägnierten Verstärkungsfaserschichten und aus Metallschichten in beliebiger Anordnung. Im einfachsten Fall ist eine kunststoffimprägnierte Faserschicht mit einer Metallschicht verbunden. Auch eine "Sandwich"-Struktur mit einer Metallschicht zwischen zwei verstärkten Kunststoffschichten oder eine verstärkte Kunststoffschicht zwischen zwei Metallschichten ist möglich sowie natürlich Gebilde mit mehreren alternierenden Metall- und verstärkten Kunststoffschichten.

Flächengebilde aus Verstärkungsfasern im Sinne der Erfindung sind in erster Linie Gewebe, Gewirke, Gestricke und Faservliese. Geeignete Verstärkungsfasern sind beispielsweise anorganische Verstärkerfasern, beispielsweise aus anorganischen Materialien wie silikatische und nicht-silikatische Gläser der verschiedensten Art, Kohlenstoff, Bor, Siliciumcarbid, Metalle, Metallegierungen, Metalloxide, Metallnitride, Metallcarbide und Silikate, sowie organische Fasern von natürlichen und synthetischen Polymeren, beispielsweise Polyacrylnitrile, Polyester, ultrahochgereckte Polyolefinfasern, Polyamide, Polyimide, Aramide, Liquid-Crystal-Polymere, Polyphenylensulfide, Polyetherketone, Polyetheretherketone, Polyetherimide, Baumwolle und Cellulose. Bevorzugt sind hochschmelzende Materialien, beispielsweise Gläser, Kohlenstoff, Aramide, Liquid-crystal-Polymere, Polyphenylensulfide, Polyetherketone, Polyetheretherketone und Polyetherimide.

Die Verstärkungsfasern können in dem erfindungsgemäßen Verbundstoff gleichmäßig verteilt sein, sie können jedoch auch in bestimmten Teilen des Werkstoffs, z.B. in den Randbereichen und/oder besonderen Verstärkungszonen, in einem größeren Anteil vorhanden sein als in anderen Teilen des Werktoffes.

Flächengebilde aus thermoplastischen Kunststoffen sind Folien oder aus Fasern hergestellte Flächengebilde wie bei den Verstärkungsfasern.

Flächengebilde aus Metallen sind ebenfalls bevorzugt Folien, aber auch z.B. aus Drähten hergestellte Flächengebilde wie Netze, Gewebe, Gewirke.

Erfindungsgemäß einsetzbare Kunststoffe sind z.B. Thermoplaste im weitesten Sinne, d.h. Stoffe, die sich reversibel oder intermediär thermoplastisch verhalten, z.B. thermoplastische Kunststoffe und thermoplastische Phasen von Duromeren. Beispiele für Thermoplaste sind Polyolefine, Vinylpolymerisate wie Polyvinylhalogenide, Polyvinylester, Polyvinylether, Polyacrylate, Polymethacrylate und organische Celluloseester, sowie Polyamide, Polyurethane, Polyharnstoffe, Polyimide, Polyester, polyether, Polystyrole, Polyhydantoine, Polyphenylenoxide, Polyphenylensulfide, Polysulfone, Polycarbonate, Phenolharzvorläufer, Furanharzvorläufer, Melaminharzvorläufer, Epoxidharzvorläufer, Verbindungen mit polymerisations- und/oder polyadditionsfähigen Doppelbindungen, Polyimidvorläufer, Polyetherketone, Polyetheretherketone, Polyethersulfone, Polyetherimide, Polyamidimide, Polyfluoralkene, Polyestercarbonate und Liquid-crystal-Polymere; ferner unpolare thermoplastische Polymere (z.B. Polyolefine), denen polare Gruppen aufgepfropft wurden.

Bevorzugte Thermoplaste sind Polyethylene, Polypropylene, Polybutylene, Polypentene, Polyvinylchloride, Polymethylmethacrylate, Polyacrylnitrile, Polymethacrylnitrile, Polystyrol enthaltende Mehrphasenkunststoffe wie ABS, Polyamide des Typs 6, Polyamide des Typs 6-6, Polyurethane, Polyethylenterephthalate, Polybutylenterphthalate, Bisphenol-A-Polycarbonate, Polyphenylensulfide, Polyetherketone, Polyetheretherketone, Polyethersulfone, Polysulfone, Polyetherimide, Polyamidimide, Polyestercarbonate, Liquid-crystal-Polymere und Polypropylen, dem polare Gruppen aufgepfropft wurden.

Die Thermoplaste können auch in den verschiedensten Kombinationen vorliegen, z.B. als Copolymere, Blockcopolymere, Pfropfpolymere, Mischpolymere und Polymergemische.

Die Kunststoffe können auch in Pulverform oder als Schmelze zugegeben werden.

Geeignete Metalle sind z.B.

Aluminium, Blei, Bronze, Chrom, Eisen, Gold, Kupfer, Messing, Molybdän, Nickel, Silber, Stahl, Titan, Zink und Zinn, vorzugsweise Aluminium und Kupfer.

Die Metalle können auch in Pulverform oder als Späne zugegeben werden.

Zur Herstellung der Laminate kann man im allgemeinen wie folgt vorgehen:
Die Herstellung der Laminate erfolgt vorzugsweise auf Doppelbandpressen, mit denen sich in einem sehr wirtschaftlichen Verfahren große Mengen des Verbundstoffes herstellen lassen.

Flächengebilde aus Verstärkungfasern, thermoplastischen Kunststoffen und Metallen werden beispielsweise in alternierender Schichtfolge gemeinsam in den Spalt einer Doppelbandpresse eingezogen. Die Doppelbandpresse weist bei Aufgabe der Thermoplasten in Form von Folien oder Pulvern mindestens eine Heizzone und eine Kühlzone auf.

Die erfindungsgemäß hergestellten Laminate und ihre Verwendung beispielsweise als Leiterplatten sind prinzipiell bekannt. So beschreibt die europäische Patentschrift 291 629 ein Verfahren zur Herstellung einer mit einer Kupferfolie beschichteten, harzgetränkten Gewebebahn. Dieses Verfahren geht aber von der fertigen harzgetränkten Gewebebahn aus und führt nicht zu einem völlig befriedigenden Ergebnis.

Beispiele

Beispiel 1
_____  _

In alternierender Reihenfolge wurde Polyamid 6-Folie und Glasgewebe, (Leinwandbindung, Hersteller Interglas, Qualität 92150 mit 345 g/m² Flächengewicht; Kette 6"68"5 tex; Schuß 5, 3"272 tex), mit einer Breite von 600 mm übereinander mit Aluminium-Folie als Hüllschichten in eine Doppelbandresse eingezogen. Bei einer Temperatur von 340°C, einem Druck von 13 bar und einer Abzugsgeschwindigkeit von 1,5 m/min wurde ein Produkt mit sehr guten Hafteigenschaften hergestellt. Die Kernschicht ohne Aluminiumfolie hat einen Glasgehalt von 74 Gew.-% und einen Polyamid 6-Gehalt von 26 Gew.-%. Der Biege-E-Modul beträgt 26,3 GPa, die Biegefestigkeit 145 MPa und die Dehnung 2,2 %, ermittelt im Biegeversuch.

Beispiel 2
_____  _

In alternierender Reihenfolge wurden Polyamid 6-Folie und Kupfergewebe in eine Doppelbandpresse eingezogen. Bei einer Temperatur von 340°C, einem Druck von 20 bar und einer Abzugsgeschwindigkeit von 1,2 m/min wurde ein Produkt mit sehr guten Abschirmungseigenschaften hergestellt. Der Verbundstoff hat einen Kupfergehalt von 40 Vol.-% und einen Polyamid 6-Gehalt von 60 Vol.-%.

Die Produkte zeichnen sich durch die Kombination großer Festigkeit mit charakteristischen Metalleigenschaften, (wie elektrische Leitfähigkeit, elektromagnetische Abschirmung, Glanz, Lösungsmittelbeständigkeit) aus.

**Patentansprüche**

1. Verfahren zur kontinuierlichen Herstellung von laminierten Flächengebilden aus thermoplastischen Kunststoffen, Verstärkungsfasern und Metallen, dadurch gekennzeichnet, daß man thermoplastische Kunststoffe, Metalle und endlose Flächengebvilde aus Verstärkungsfasern schichtweise vereinigt, und die vereinigten Schichten kontinuierlich während einer Zeit von 0,1 bis 10 Minuten bei einer Temperatur von 20 bis 150°C über dem Schmelzpunkt des thermoplastischen Kunststoffs einem Druck von 0,5 bis 50 bar aussetzt.

2. Verfahren nach Anspruch 1, dadurch gekennzeichnet, daß der thermoplastische Kunststoff und das Metall ebenfalls in Form endloser Flächengebilde vorliegen.

3. Verfahren nach Anspruch 1, dadurch gekennzeichnet, daß der thermoplastische Kunststoff in Pulverform oder als Schmelze aufgetragen wird.

4. Verfahren nach Anspruch 1, dadurch gekennzeichnet, daß das Metall in Pulverform oder als Späne zugefügt wird.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl⁵) |
|---|---|---|---|
| A | <u>DE - A1 - 3 413 434</u><br>(DIELEKTRA)<br>  * Zusammenfassung *<br>-- | 1,2 | B 32 B 31/08<br>B 32 B 31/20<br>B 32 B 15/14<br>B 32 B 15/08<br>B 32 B 15/20 |
| A | <u>EP - A2 - 0 327 838</u><br>(HELD)<br>  * Spalte 1, Zeilen 4-28;<br>   Spalte 4, Zeilen 23-33 *<br>-- | 1,2 | |
| A | <u>DD - A5 - 250 090</u><br>(PRESIDENT ENGINEERING)<br>  * Patentansprüche 1-8; Seite<br>   2, Zeilen 1-17; Seite 12,<br>   Zeilen 4-9 *<br>-- | 1-3 | |
| A | <u>DE - C2 - 3 238 160</u><br>(HITACHI)<br>  * Spalte 2, Zeilen 10-36;<br>   Spalte 4, Zeilen 54-68;<br>   Spalte 8, Zeilen 27-36 *<br>-- | 1-3 | |
| D,A | <u>EP - A2/A3 - 0 291 629</u><br>(AEG ISOLIER- UND KUNSTSTOFF<br>GMBH)<br>  * Zusammenfassung *<br>-- | 1,2 | **RECHERCHIERTE SACHGEBIETE (Int Cl⁵)**<br><br>B 32 B 31/00<br>B 32 B 15/00 |
| A | <u>DE - A1 - 3 200 593</u><br>(GENERAL ELECTRIC)<br>  * Patentanspruch 1; Seite 6,<br>   Zeilen 14-22; Seite 4, Zei-<br>   len 2-5 *<br>---- | 4 | |

Der vorliegende Recherchenbericht wurde für alle Patentansprüche erstellt.

| Recherchenort | Abschlußdatum der Recherche | Prüfer |
|---|---|---|
| WIEN | 14-02-1991 | ONDER |